# EUROPÄISCHE PATENTSCHRIFT

(11) **EP 0 503 138 B1**
(45) Veröffentlichungstag und Bekanntmachung des Hinweises auf die Patenterteilung: **20.11.1996**
(21) Anmeldenummer: 91118410.9
(22) Anmeldetag: 29.10.1991
(51) Int. Cl.: H01J 37/34

(54) **Vorrichtung für den Antrieb der Magnetanordnung eines planaren Magnetron für eine Sputteranlage**
Device for actuating a magnet arrangement of a planar magnetron for a sputtering facility
Dispositif pour actionner un appareil à aimants d'un magnétron planar pour une installation de pulvérisation cathodique

(30) Priorität: 08.03.1991 DE 4107505
(43) Veröffentlichungstag der Anmeldung: 16.09.1992
(73) Patentinhaber: Balzers und Leybold Deutschland Holding Aktiengesellschaft, 63450 Hanau (DE)
(72) Erfinder: Latz, Rudolf, Dr., W-6054 Rodgau 2 (DE)

(56) Entgegenhaltungen:
- EP-A- 0 169 680
- EP-A- 0 213 922
- EP-A- 0 399 710
- PATENT ABSTRACTS OF JAPAN vol. 7, no. 263 (C-196) 24. November 1983 & JP-A-58 144 474

## Beschreibung

Die Erfindung betrifft eine Vorrichtung für den Antrieb einer Magnetanordnung eines planaren Magnetrons für eine Sputteranlage, mit einem ortsfesten Motor, einem gegenüber dem Sputtertarget bewegbar gelagerten Magnetjoch, und mit einer mit dem Magnetjoch in Wirkverbindung stehenden, Exzenternocken aufweisenden Exzenterscheibe. Eine solche Vorrichtung ist aus EP-A-0 399 710 und aus EP-A-0 213 922 bekannt.

Es werden reaktionsfähige Gase, wie O₂, N₂, CH₄, H₂S u.a. eingesetzt. Beim Beschichtungsprozeß entstehen die entsprechenden Verbindungen: Oxide, Nitride, Carbide oder Sulfide, die als Schichten auf einem Substrat aufgetragen werden. Dieser reaktive Zerstäubungsprozeß hat sich in der Fertigungstechnik sehr bewährt. Er hat u.a. den Vorteil, daß er die Herstellung von chemischen Verbindungen reproduzierbar macht. Als Beispiel sei erwähnt, daß mit derartigen reaktiven Sputterprozessen transparente leitende Schichten für Flüssig-Kristall-Anzeigen (LCD = Liquid Cristal Display) hergestellt werden.

Bekannt sind eine Gleichspannungszerstäubung und eine Hochfrequenzzerstäubung sowie Mischformen. Außerdem ist Sputtern mit Bias (Vorspannung) bekannt.
Dabei werden Substrate auf einen elektrisch isolierten Substratträger gelegt, der eine, verglichen mit der Katode, kleine negative Vorspannung hat.

Die Gleichspannungszerstäubung ist auf elektrisch leitende Materialien als Katode (Target) beschränkt, da bei nicht leitender Katode der Strom durch den Isolator unterbrochen ist.

Die erwähnte Hochfrequenzzerstäubung wird benutzt, um auch Isolatoren zu zerstäuben. Die Elektroden der Sputteranlage werden dabei durch eine Hochfrequenz-Quelle versorgt.

Bei Zerstäubungsprozessen werden in der Praxis u.a. solche Hochleistungszerstäubungsvorrichtungen eingesetzt, bei denen durch ein Magnetfeld vor der Katode die Kollisions- und damit lonisationswahrscheinlichkeit der Teilchen erhöht wird.

Eine derartige Hochleistungszerstäubungsvorrichtung wird beispielsweise in der deutschen Patentschrift 241 728 8 beschrieben.

Dort wird eine Katodenzerstäubungsvorrichtung mit hoher Zerstäubungsrate mit einer Katode, die auf einer ihrer Oberflächen das zu zerstäubende und auf einem Substrat abzulagernde Material aufweist, mit einer derart angeordneten Magneteinrichtung, daß von der Zerstäubungsfläche ausgehende und zu ihr zurückkehrende Magnetfeldlinien einen Entladungsbereich bilden, der die Form einer in sich geschlossenen Schleife hat und mit der einer außerhalb der Bahnen des zerstäubten und sich von der Zerstäubungsfläche zum Substrat bewegenden Materials angeordneten Anode gezeigt.

In der genannten Patentschrift wird vorgeschlagen, daß die zu zerstäubende und dem zu besprühenden Substrat zugewandte Katodenfläche eben ist, daß sich das Substrat nahe dem Entladungsbereich parallel zu der ebenen Zerstäubungsfläche über diese hinwegbewegen läßt und daß die das Magnetfeld erzeugende Magneteinrichtung auf der der ebenen Zerstäubungsfläche abgewandten Seite der Katode angeordnet ist.

Die vorstehend beschriebene Hochleistungszerstäubungsvorrichtung (Magnetron Sputtering) hat zwar die Vorteile niedriger Substrattemperatur, hoher Kondensationsrate und damit verbunden hoher Reinheit der aufgetragenen Schicht, andererseits wird jedoch die schlechte Target-Ausnutzung infolge der inhomogenen Erosion als nachteilig empfungen.

Hier setzt die Erfindung ein.
Sie macht sich zur Aufgabe, eine weitgehend homogene Erosion des Targets möglich zu machen. Damit wird eine verbesserte Targetausnutzung beim Sputtern erreicht. Der Verbrauch von teurem Targetmaterial gestaltet sich ökonomischer.

Es gehört weiterhin zur Aufgabenstellung, beim reaktiven Sputtern eine isolierende Belegung auf der Targetoberfläche zu vermeiden.

Grundsätzlich soll durch die Erfindung die Stabilität reaktiver Sputterprozesse erhöht werden.

Die Verwirklichung des der vorliegenden Erfindung zugrundeliegenden Prinzips ist nicht beschränkt auf eine Katodenzerstäubung, wie sie in der oben genannten deutschen Patentschrift 241 728 8 beschrieben wird.
Der Gegenstand der Erfindung ist universell überall dort einsetzbar, wo es um die Erzielung einer homogenen Erosion des Targets geht.

Die gestellten Aufgaben werden erfindungsmäß gelöst durch einen die Exzenterscheibe mit der Antriebswelle des Motors verbindenen Antriebsriemen, eine mit der Antriebswelle verbundene, elliptisch ausgeformte, die Drehbewegung auf die Exzenterscheibe übertragende Riemenscheibe und eine auf dem Riemen abrollende, im übrigen federnd gelagerten Spannrolle.

Die Erfindung läßt die verschiedensten Ausführungsmöglichkeiten zu; eine davon ist in den anhängenden Zeichnungen schematisch dargestellt und zwar zeigen:
- Figur 1: eine Sputteranlage nach dem Stand der Technik und
- die Figuren 2: eine Vorrichtung nach der Erfindung in der Seitenansicht.

Bei der nachfolgenden Beschreibung eines Ausführungsbeispiels der Erfindung wird von einem Stand der Technik ausgegangen, wie er sich in Form der deutschen Patentschrift 241 728 8 darstellt.

Die Beschreibung und die Figuren dieser Schrift können zur Erläuterung der Ausgangsbasis für das nachfolgend beschriebene Ausführungsbeispiel der Erfindung herangezogen werden.

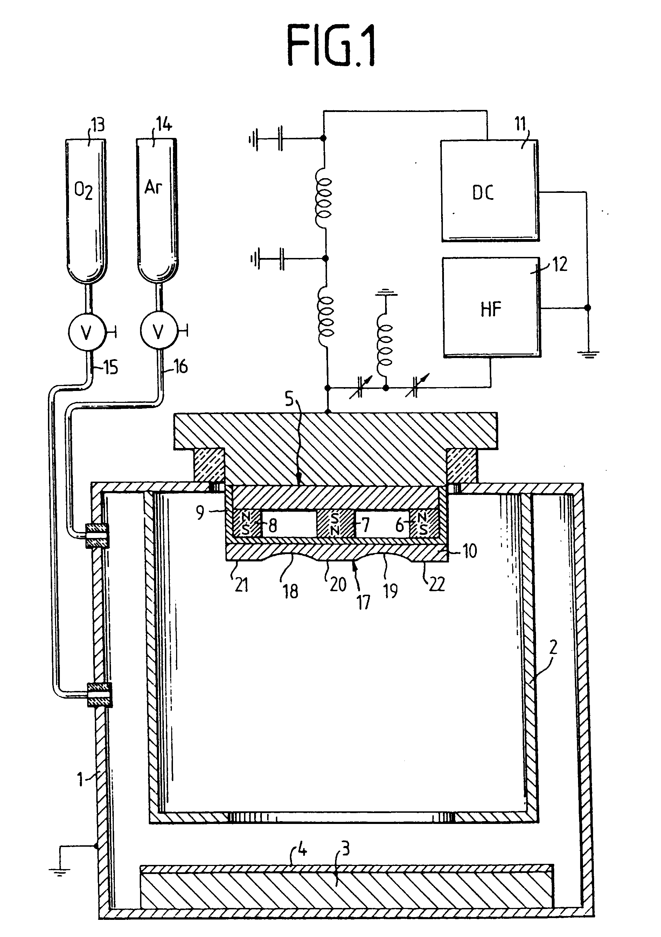

In Figur 1 werden die wesentlichen Bestandteile einer an sich bekannten Sputteranlage gezeigt. Es handelt sich hierbei um den Rezipienten, der in seiner Gesamtheit mit 1 bezeichnet ist. Im Rezipienten ist ein Abschirmkasten 2 angeordnet. Auf dem Boden des Rezipienten befindet sich das Substrat 3. Während des Sputtervorgangs wird auf dem Substrat die Schicht 4 aufgetragen. Während des Sputtervorgangs steht der Innenraum des Rezipienten bzw. des Abschirmkastens unter Vakuum, genauer gesagt, der Druck im Rezipienten wird auf das für den Sputterprozeß notwendige niedrige Druckniveau gebracht.

Im oberen Bereich des Rezipienten befindet sich die planare Magnetronkatode, die in ihrer Gesamtheit mit 5 bezeichnet ist. Einzelheiten dieser Hochleistungskatode sind der eingangs erläuterten deutschen Patentschrift 241 728 8 zu entnehmen.

Charakteristisch für die Hochleitungskatode sind das Magnet-Array, bestehend aus den Magneten 6, 7 ,8. Das Magnet-Arry ist in der Katodenwanne 9 untergebracht.

Auf der dem Zentrum des Rezipienten zugewandten Seite der Katodenwanne befindet sich das Target 10.

Die vorliegende Sputteranlage ist mit einer DC-Energieversorgungseinheit 11 und einer HF-Energieversorgungseinheit 12 ausgerüstet.

Mit 13 und 14 sind ein O₂-Behälter, beziehungsweise ein Ar-Behälter bezeichnet. Über die Leitungen 15 und 16 gelangen O₂ und Ar in den Rezipienten.

Sie bilden dort das für den reaktiven Sputtervorgang notwendige reaktive Gasgemisch bzw. die notwendige reaktive Gasatmosphäre.

Auf der Targetoberfläche 17 sind erodierte Bereiche 18, 19 zu erkennen (Erosionsgräben).

Zwischen diesen Erosionsgräben befindet sich ein mittlerer Bereich 20, der nicht oder nicht stark erodiert ist. Ebenso sind die Randbereiche 21, 22 nicht oder nicht stark erodiert.

Das in Figur 1 gezeigte Erosionsbild mit der inhomogenen Erosion ist typisch für Anlagen des Standes der Technik. Mit dem Gegenstand der Erfindung soll erreicht werden, daß eine homogene oder weitgehend homogene Erosion in allen Bereichen der Oberfläche des Targets stattfindet.

Die Grundidee, die der Erfindung zugrundeliegt, kann in mannigfaltiger Weise verfahrensgemäß und apparativ verkörpert werden. Dies ist beispielsweise in der Anspruchsfassung und in der Beschreibungsanleitung beschrieben.

Das nachfolgend beschriebene Ausführungsbeispiel ist daher nur eines von vielen praktischen Lösungsmöglichkeiten.

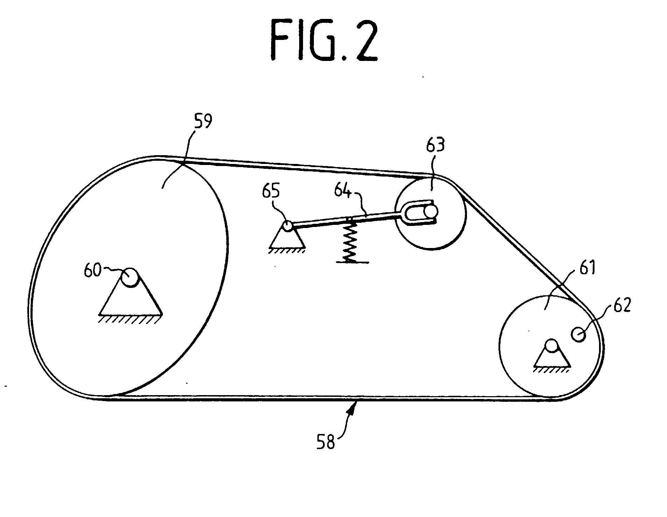

Beim Ausführungsbeispiel nach Figur 2 wird ein Sputtermagnetfeld, dessen Magnete auf einem Joch angeordnet sind, im Wannenraum nach einer bestimmten Steuercharakteristik von einem Riementrieb hin- und herbewegt (nicht näher dargestellt). Um diese Bewegungen zu ermöglichen, sind die Abmessungen des Jochs kleiner als der von der Katodenwanne begrenzte Wannenraum.

Die eigentliche Magnetanordnung wird über ein Kurbelgetriebe bewegt, wodurch eine Bewegung des Plasmas vor der Oberfläche des Targets erreicht wird. Durch die Bewegung der Magnetanordnung ist es möglich, daß das Plasma auch in die Randbereiche und in den mittleren Bereich seine erodierende Wirkung ausübt und zwar für eine längere Verweildauer, so daß eine weitgehend homogene Targetausnutzung erzielt wird.

In Figur 2 sind die wesentlichen Details des Riemengetriebes für eine Hin- und Herbewegung der Magnetanordnung schematisch dargestellt. Der Antriebsriemen 58 wird durch das elliptisch geformte Rad 59 angetrieben. Dieses elliptische Rad sitzt auf der Motorwelle 60. Mit 61 ist ein kreisrundes Rad bezeichnet, das einen Exzenternocken 62 aufweist. Mit 63 ist eine Spannrolle oder Andrückrolle bezeichnet, die unter der Wirkung beispielsweise einer Feder den Antriebsriemen gespannt hält. Die Spannrolle schwingt dabei mit ihrem Hebel 64 um die Achse 65.

Wird nun das elliptische Rad 59 mit konstanter Winkelgeschwindigkeit angetrieben, so ergeben sich beim kreisrunden Rad 61 fortlaufend Winkelbeschleunigungen und Winkelverzögerungen. Dies wird ausgenutzt, um über den Nocken 62 das Magnetaggregat so zu bewegen, daß die Verweilzeiten in den normalerweise wenig erodierten Bereichen des Targets vergrößert werden.

### Liste der Einzelteile

- 1: Rezipient
- 2: Abschirmkasten
- 3: Substrat
- 4: Schicht
- 5: Magnetronkatode
- 6: Magnet
- 7: Magnet
- 8: Magnet
- 9: Katodenwanne
- 10: Target
- 11: Einheit
- 12: Einheit
- 13: 02-Behälter
- 14: Ar-Behälter
- 15: Leitung
- 16: Leitung
- 17: Targetoberfläche
- 18: Bereich
- 19: Bereich
- 20: Bereich
- 21: Bereich
- 22: Bereich
- 58: Riemen
- 59: elliptisches Rad
- 60: Welle
- 61: Rad
- 62: Exzenternocken
- 63: Rolle
- 64: Hebel
- 65: Achse

## Patentansprüche

1. Vorrichtung für den Antrieb einer Magnetanordnung eines planaren Magnetrons für eine Sputteranlage, mit einem ortsfesten Motor, einem gegenüber dem Sputtertarget bewegbar gelagerten Joch der Magnetanordnung, und mit einer mit dem Magnetjoch in Wirkverbindung stehenden, Exzenternocken (62) aufweisenden Exzenterscheibe (61), gekennzeichnet durch einen, die Exzenterscheibe (61) mit der Antriebswelle (60) des Motors verbindenden Antriebsriemen (58), eine mit der Antriebswelle (60) verbundene, elliptisch ausgeformte, die Drehbewegung auf die Exzenterscheibe (61) übertragende Riemenscheibe (59) und einer, auf dem Riemen (58) abrollenden, im übrigen federnd gelagerten Spannrolle (63).

## Claims

1. Apparatus for operating a magnet arrangement of a planar magnetron for a sputtering plant, comprising a stationary motor, a yoke of the magnet arrangement mounted movably opposite the sputter target and comprising a cam disc (61) having a cam (62) actively engaged with the magnet yoke, characterised by a drive belt (60) connecting the cam disc (61) to the drive shaft (60) of the motor, an elliptically formed belt disc (59) connected to the drive shaft (60) and transmitting the rotary motion to the cam disc (61), and a tension pulley (63) rolling over the belt (58) and furthermore resiliently mounted.

## Revendications

1. Dispositif d'entraînement d'un groupement d'aimants d'un magnétron de type planar pour une installation de pulvérisation cathodique, comportant un moteur en position fixe, une culasse du groupement d'aimants portée avec liberté de mouvement par rapport à la cible de la pulvérisation cathodique, ainsi qu'une poulie à excentrique (31) présentant un bossage excentrique (62) relié positivement à la culasse des aimants, caractérisé par une courroie d'entraînement (58) reliant la poulie à excentrique (61) avec l'arbre d'entraînement (60) du moteur, par une poulie à courroie (59) reliée à l'arbre d'entraînement (60), de forme elliptique, transmettant le mouvement de rotation à la poulie à excentrique (61) et par un rouleau de tension (103) roulant sur la courroie (58) et porté élastiquement par ailleurs.
